# EUROPEAN PATENT APPLICATION

(11) **EP 4 672 313 A1**
(43) Date of publication of application: **31.12.2025**
(21) Application number: 25173862.1
(22) Date of filing: 01.05.2025
(51) Int. Cl.: H01L 23/00

(54) **DYNAMIC SUBSTRATE THERMAL DISPLACEMENT COMPENSATION**

(30) Priority: 24.06.2024 US 202418752762
(71) Applicant: INTEL Corporation, Santa Clara, CA 95054 (US)
(72) Inventor: OKA, Mihir, 85296 Gilbert, AZ (US); MELLODY, James, 85021 Phoenix, AZ (US); SRINIVASAN, Kartik, 85298 Gilbert, AZ (US); TAN, Wei, 85248 Chandler, AZ (US); CETEGEN, Edvin, 85226 Chandler, AZ (US); GOKHALE, Shripad, 85298 GILBERT (US); KAYA, Mine, 85226 Chandler, AZ (US); SINGH, Yuvraj, 85226 Chandler, AZ (US)
(74) Representative: HGF

(57) **Abstract**

In some embodiments, methods and apparatuses for performing thermal compression bonding and compensating for thermal displacement are provided.

## Description

### TECHNICAL FIELD

Embodiments relate generally to the field of semiconductor manufacturing and more specifically, to the field of bonding an IC device to a substrate.

### BRIEF DESCRIPTION OF THE DRAWINGS

The disclosure may best be understood by referring to the following description and accompanying drawings that are used to illustrate embodiments of the invention. In the drawings:
Figs. 1A-1D are diagrams illustrating thermal drift between a substrate and an IC device to be bonded to the substrate.
Figs. 2A and 2B are diagrams showing a TCB apparatus 200 with dynamic thermal displacement compensation in accordance with some embodiments.
Fig. 3 is a flow diagram showing a routine 300 for bonding IC devices to a substrate in accordance with some embodiments.
Figs. 4A and 4B are diagrams showing a TCB apparatus 400 with dynamic thermal displacement compensation in accordance with some embodiments.
Fig. 5 illustrates an example computing system that may be formed from one or more IC devices bonded to a substrate in accordance with some embodiments.

### DETAILED DESCRIPTION

Thermocompression bonding (TCB) is a method of joining two metal surfaces together by applying heat and pressure simultaneously. With semiconductor manufacturing, TCB processes are commonly used, e.g., in vertical integration, to connect to one another associated metal contacts from one integrated circuit (IC) device to another. For example, multi-chip assemblies may have multiple different IC devices (e.g., die device, multi-die device, or die package device) bonded to a common substrate such as an organic package substrate, a multi-die package substrate, or a printed circuit board (PCB) substrate, or another type of substrate.

The bonding process involves the application of both heat (e.g., 250 to 450 °C) and pressure (e.g., 0.5 N to 80 KN) to bring the associated metal contact surfaces into intimate atomic contact with each other and enable diffusion processes to merge them together. Some beneficial characteristics of TCB include high fracture toughness, excellent electrical conductivity, and hermetic sealing.

However, a challenge with TCB processes is thermal expansion while the contacts are being joined. For example, substrate expansion during bonding can result in a misalignment between an IC devices contacts and those from the substrate. There are two primary sources of expansion caused alignment error. The first challenge is the disproportional expansions of the contact areas for the devices being bonded together. That is, a contact area from one device may expand more greatly than the contact area from the other contacts. This problem, however, may be mitigated with a thermal expansion compensation in designing dimensions for one or both of the contact areas relative to each other such that their contact areas are sufficiently equivalent when bonding occurs.

The second issue is a bit more challenging. As the contacts from devices to be joined are being mated to one another, one of the devices (e.g., substrate) may drift away from the other device's contact area, causing the contacts to be misaligned during the bonding (heating and cooling) processes. In fact, when the target device such as a substrate is larger than the bond head device (the device being bonded to the target by a bond head assembly), the problem can be exacerbated, especially when the target contact region is further away from the center of the target device.

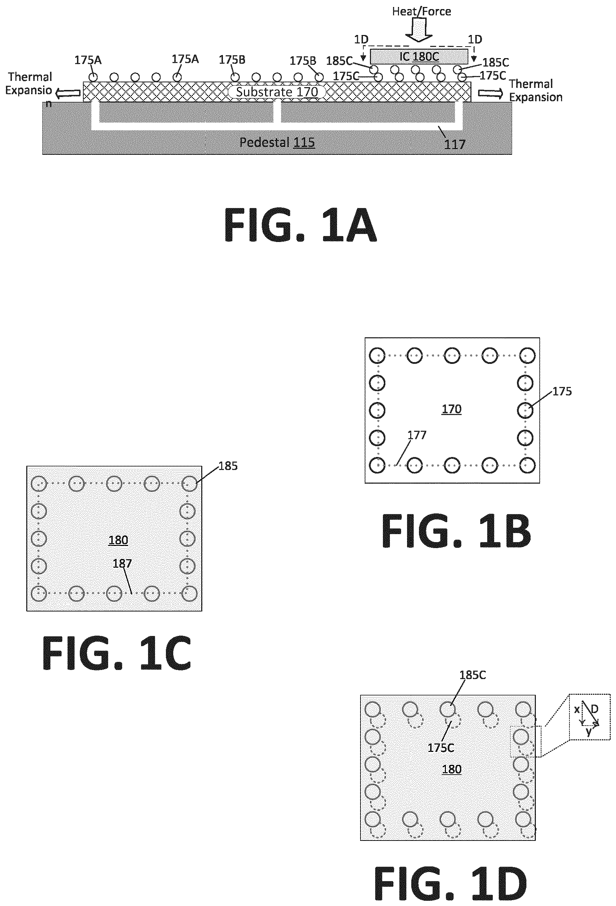

Figs. 1A-1D are diagrams illustrating thermal drift between a substrate and an IC device to be bonded to the substrate. Fig. 1A is a side view showing an IC device (or simply device or IC) 180 being bonded to a portion of a substrate 170. Fig. 1B is a top view illustrating a target contact area 177 for the substrate 170, the target contact area 177 being defined by a set of contacts 175. Similarly, Fig. 1C is an underside view illustrating a device contact area 187 defined by a set of device contacts 185. Fig. 1D is a top view illustrating thermal drift between the device 180 and substrate 170.

During a TCB (thermal compression bonding) process, the substrate 170 is secured upon a pedestal 115 through a vacuum suction mechanism 117 to hold it in place while the device 180 is bonded onto the substrate 170.

In this illustration, the substrate has three sets of contacts (175A-175C) to receive corresponding contacts 185 from devices that are to be bonded to the substrate 170. In the depicted embodiment, an initial device 180C to be bonded is shown with its set of contacts 185C to be bonded to corresponding substrate contacts 175C of substrate 170.

The pedestal is typically heated (e.g., up to 300 degrees C), while a bond head assembly (not shown) holding and positioning the IC device 180C is also heated (e.g., from 200 to 400 degrees C). This causes both the substrate and device to be heated, which in turn, causes their contacts to also be heated. As they are so heated, the bond head forces the device down, merging associated contacts from the device and substrate to one another.

In some embodiments, the substrate may be formed from a material, e.g., organic (or at least partially organic) material that may have a coefficient of thermal expansion (CTE) that is higher (e.g., 5X to 10X) than that of the IC device. In addition, as shown in the figure, it also may be larger than the IC, exaggerating even further thermal expansion/contraction discrepancies between the device (es) and substrate. This is illustrated in both Figs. 1A and 1D. The target contact area (area defined by substrate contacts 175C) expand at a greater rate than the device contact area, resulting in a displacement (D) having displacement in both X and Y directions.

Traditional solutions have employed static X, Y placement offsets to compensate for substrate expansion drift problems during bonding. With such solutions, the placement offset may be equal and opposite to measured post bonding offsets taken from sample test cases. This results in lower device to substrate displacement at the end of bonding, but it sacrifices device contact to target contact alignment through the bulk of the bonding process. At the start of bonding, the device contacts are shifted ahead, relative to the target contacts, in the direction, and with a magnitude, corresponding to anticipated target expansion. However, as the substrate is expanding during contact bonding, the device to substrate offset changes. This makes the contact bonds susceptible to solder bridging during a large portion of the bonding process. Moreover, the magnitude of the required offset compensation can change from run to run and with different tools and tool conditions.

Accordingly, in some embodiments, approaches facilitating dynamic compensation based on monitored substrate expansion and contraction are provided. In some implementations, a displacement tracking system may track the positions of substrate edges and corners during bonding in order to control device positioning based on substrate expansion and contraction. For example, net substrate surface displacement vectors, in both X and Y directions, can be determined to derive overall misalignment vectors and used to control device position to reduce die to substrate misalignment during the TCB bonding process. In some embodiments, for example, this can enable pitch scaling to tighter pitches, e.g., pitches below 40 uM. This may be valuable, especially when bonding composite dies that can require high amounts of heating.

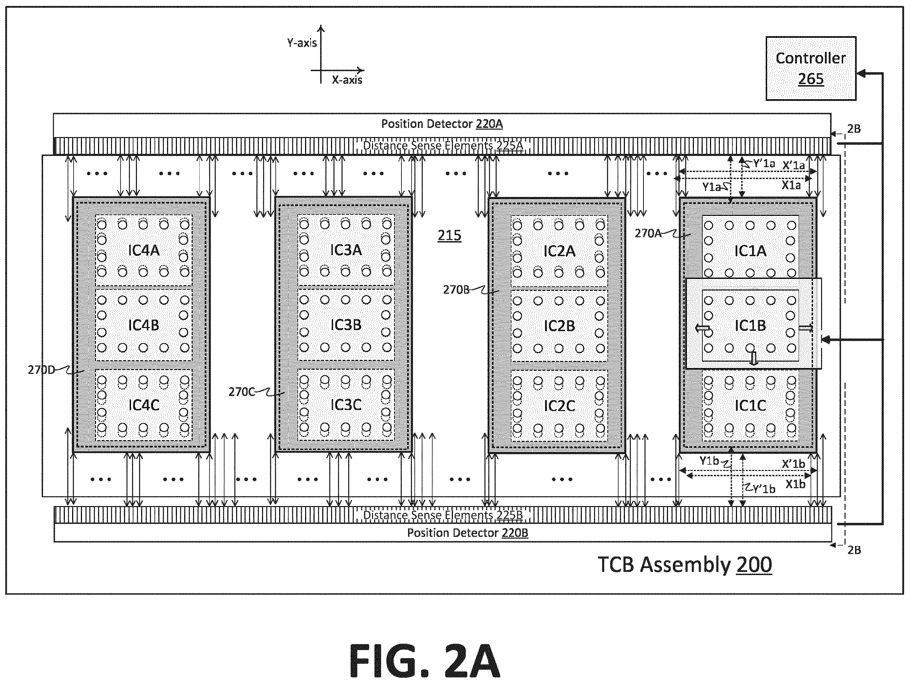

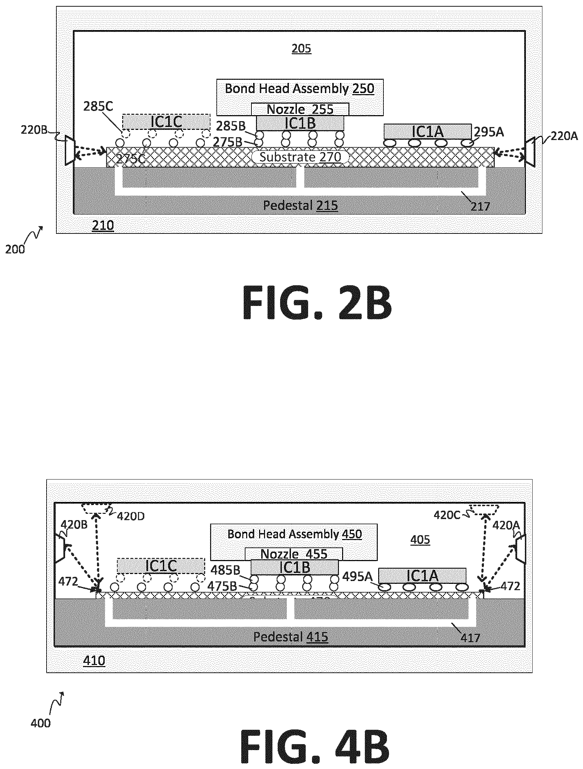

Figs. 2A and 2B are diagrams showing a TCB apparatus 200 with dynamic thermal displacement compensation in accordance with some embodiments. Fig. 2A is a top view of the TCB apparatus, and Fig. 2B is a section view of the apparatus of Fig. 2A taken along lines 2B-2B. The apparatus 200 generally includes a bond housing 210 defining a closed chamber 205 where TCB bonding occurs. It includes a pedestal (or bond stage) 215, position detectors 220A, 220B, bond head assembly 250 and controller circuit 265.

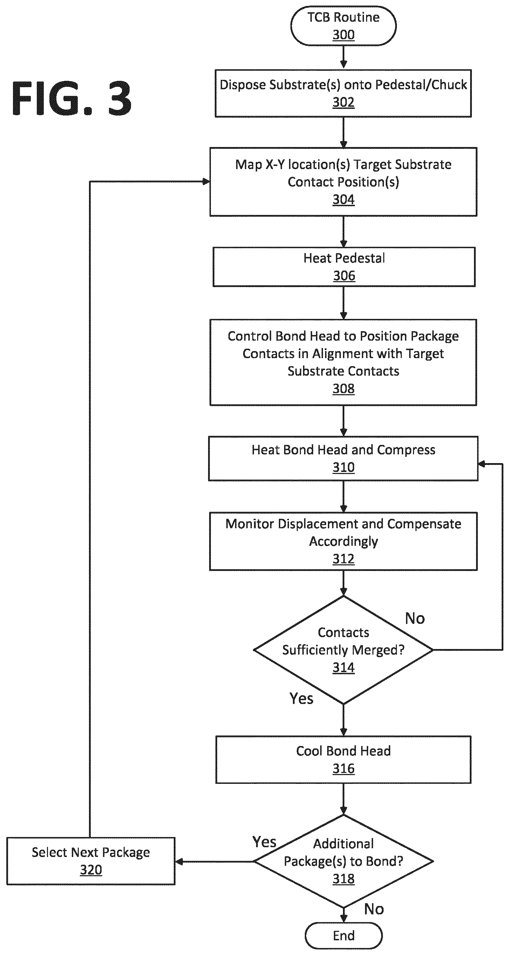

The pedestal 215 has a vacuum suction mechanism 217 to hold substrates 270 (270A-270D) in place while the IC devices (IC1A through IC4C) are bonded to them by the bond head while it is bonded to a set of target contacts 275 on a substrate 270. The bond head assembly has 3-dimensional (X-Y-Z) position control actuators (not shown) to position an IC (also referred to as device or IC device) onto a contact set target based on control signals from controller circuit 265. The controller circuit may include any suitable combination of processors, micro-controllers, finite state machines, analog circuitry and/or sensors to implement a TCB bonding process with dynamic displacement tracking. For example, it may implement a routine in accordance with the flow diagram of Fig. 3 discussed below. In some embodiments, it may have, or have access to, a memory with instructions (e.g., firmware and/or programmable code) to be executed by one or more micro-controllers and/or processors to perform some or all bond head assembly and/or TCB control as described herein.

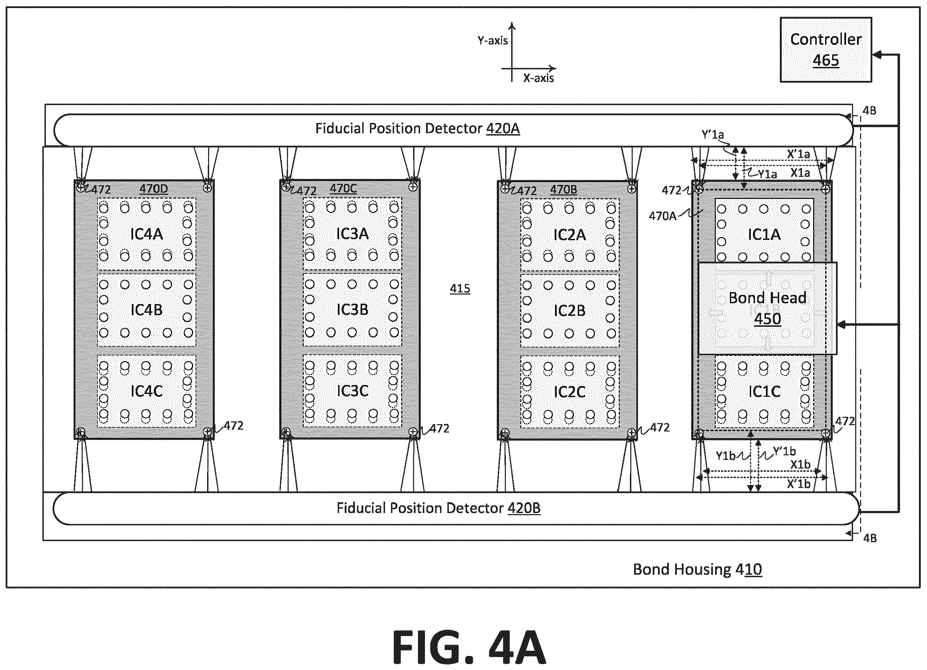

(Note that in the depicted example, Fig. 2A (as well as Fig. 4A for that matter) shows the TCB assembly as it is bonding IC1B to the substrate. In this view, IC1A has already been bonded, while the yet to be bonded positions of the other IC devices (IC1C-IC4C) are indicated with dashed lines. This is reflected in Fig. 2B, which shows IC1A having merged contacts 295A, while the other contacts, 275 and 285 have not yet been merged with one another.)

The position detectors (220A, 220B) are spaced apart and face one another to monitor opposite sides of substrates disposed there between. They allow for both X and Y direction substrate displacement to be monitored without requiring position detectors to be located at the assembly ends (or edges) that are orthogonal to the distance sensors. This may be advantageous for assemblies that allow for the pedestal 215 to be moved, for example, in both directions through a channel defined by sides of the assembly that include the position detectors (along the X-axis in this example).

The position detectors 220A, 220B include distance sense elements (225A, 225B), respectively. They are used to measure the distances from the adjacent substrate edges to the sense elements. Note that as used herein, an adjacent edge, or adjacent substrate edge, refers to an edge of a substrate that is exposed to an adjacent position detector or distance sense element that may be part of a position detector and whose distance from the position detector or sense element may be measured by the same. Any substrate shape may have an adjacent edge, which may not always correspond to a linear segment. That is, an adjacent edge refers to a portion of a substrate's side, or edge, contour that is exposed to a position detector or distance sensor and is capable of having its distance to the distance sensor measured using the same. In the depicted embodiment, uniform rectangular substrates are shown, but it should be appreciated that substrates with any suitable shape could also be monitored with distance sensors that face one another. For example circular, triangular, elliptical, trapezoidal, diamond, and other shaped substrates have adjacent edges that can be monitored using the depicted configuration.

It should be appreciated that the distance sense elements may be implemented with any suitable distance sensor technologies such as optical or capacitive distance sense schemes. For example, in some embodiments, they may include optical sense elements such as pairs of laser emitters and detectors positioned to measure the distances from the sense elements to an adjacent part of a substrate side that is in front of a particular sense element. For example, diode laser technologies such as coherently combined lasers and/or those based on GaN technologies can provide high brightness and resolution for semiconductor monitoring applications.

In the depicted embodiment, the position detectors 220A, 220B, through the distance sense elements 225A, 225B, measure a plurality of separate, parallel-aligned distances from the sensors to the substrate edges, as indicated by the solid double-ended arrows. These separate sense element distances are referred to as measured adjacent-edge distances. They may be used to determine one or more derived adjacent-edge distances for each adjacent side on each substrate. In the depicted embodiment, these distances are in the "Y" direction. Derived distances Y1a, Y'1a, Y1b, and Y'1b are shown for substrate 270A. Derived distances Y1a and Y1b are edge distances for substrate 270A before TCB occurs, while derived distances Y'1a and Y'1b are their counterpart distances after substrate expansion has occurred. Accordingly, substrate expansion/contraction displacement for adjacent edge displacement components may be tracked by the position detectors 220A, 220B, and used for adjusting bond head device positioning accordingly.

The position detectors 220A, 220B may also be used to monitor TCB substrate displacement for orthogonal substrate edges as well. As used herein, an orthogonal substrate edge is an edge, real or conceptual, that expands in a direction that is orthogonal to the expansion direction of an adjacent edge, which also may be real or conceptual. For example, with a square or rectangle, parallel sides of a substrate may correspond to adjacent edges when they are adjacent to position detectors, while the other parallel sides may correspond to orthogonal edges since they have expansion components in a direction orthogonal to the adjacent edge component expansion. A rectangle actually has orthogonal edges that are orthogonal to adjacent edges. That is, the adjacent and orthogonal edges, themselves, define 90 degree angles. But observe that even with substrate shapes not actually having physical edges orthogonal to one another, conceptual adjacent and orthogonal edges can be imposed on them for purposes of monitoring thermal displacement and compensating accordingly. This would also apply to rectangular and square substrates that don't have their physical edges oriented in parallel with position detector edges.

In the depicted embodiment, substrate orthogonal edges expand and contract along the X axis. The sense element adjacent-edge measurements may be used to monitor orthogonal edge displacement by monitoring where abrupt distance measurement changes occur for each substrate. That is, the adjacent edge distance measurements may effectively be used to define a curve whose outline conforms to an edge outline of a substrate. The shape of this substrate envelope will become wider and narrower, in the X direction for the depicted example, as the substrates expand and contract, respectively, along the Y axis. The higher the number of distinct distance measurements, the greater the resolution will be for these orthogonal displacement measurements. In the depicted example, derived orthogonal distances X1a0, X1b, X'1a, and X'1b are shown for substrate 270A. Derived distances X1a and X1b are orthogonal edge distances for substrate 270A before TCB occurs, while derived distances X'1a and X'1b are their counterpart distances after substrate expansion has occurred.

Note that any number of adjacent edge distances may be used for each substrate. For example, if uniform expansion/contraction is anticipated, one or just a few measured adjacent edge distances may be used (e.g., averaged) to generate one or more derived edge distances for use in bond head position control. On the other hand, if the substrates expand in a non-uniform manner, have irregular edge shapes, or if higher resolutions are desired, some or many different measured distances may be used to generate the one or more derived edge distance values for each adjacent side of a substrate. Not only does this allow for tracking of non-uniform substrate expansion/contraction, but also, it allows for the substrates to not have to be located in specific parts of the pedestal. In addition, it allows for different substrate sizes to be monitored. Depending on the desired resolution of substrate displacements to be monitored, more or less distance sensors may be used.

Fig. 3 is a flow diagram showing a routine 300 for bonding devices to a substrate in accordance with some embodiments. Initially, at 302, one or more substrates are disposed onto a TCB assembly pedestal (sometimes also referred to as a bond chuck). Next, at 304, the substrate contact position, or positions, are mapped, e.g., located and stored in a mapping database that is accessible to a controller circuit such as controller circuit 265. In some implementations, the bond head assembly may have a camera, on its underside, used for identifying substrate contact positions. These positions may be mapped ahead of time, before devices are bonded onto the target contacts, because, for example, the target contacts may be obstructed from the camera's view when a device is being bonded.

At 306, the pedestal is heated in order to heat the substrate(s). In some embodiments, it may be heated to a temperature in a range of between 150 and 250 degrees C. From here, at 308, the bond head retrieves a device, e.g., using its nozzle to secure the device to its underside, and based on the known position of the device's contacts and the mapped substrate target contacts, it positions the device over the target contacts in alignment therewith. At 310, the bond head is heated in order to heat the device contacts, and the device is pressed (e.g., downward) onto the substrate. The target and device contacts should be in alignment during this phase and begin merging together. At 312, it monitors any substrate displacement, relative to the target contact positions when mapped, and compensates accordingly, e.g., using a vector displacement derivation and compensation approach as discussed previously.

From here, at 314, the bond head determines if the contacts have sufficiently merged together. This may be done using pressure/force sensors in the bond head that can sense when the responsive force is sufficiently large to indicate that the contacts have sufficiently merged with one another. If not, the routine loops back to 310 and continues as described. Note that while the steps of displacement monitoring/compensation and heating/compression are shown as separate actions, they may effectively be done together, depending on the closed loop control parameters utilized for monitoring displacement and controlling device position. For example, separate control loops may simultaneously be used for device X-Y position control, on the one hand, and device heating and/or compression, on the other hand, or they may be performed in alternating stages relative to one another.

Once the contacts have sufficiently merged together, at 314, the routine proceeds to 316, and the bond head is cooled, along possibly with the pedestal as well, in order to harden the merged together contacts. From here, the routine proceeds to 316 and determines if an additional device is to be bonded onto the same, or a different, substrate in the chamber. If so, the routine goes to 320, selects another device, and then loops back to 306 and proceeds as described. On the other hand, if at 318, it determines there are no more devices to be bonded, then the routine ends.

Figs. 4A and 4B are diagrams showing a TCB apparatus 400 with dynamic thermal displacement compensation in accordance with some embodiments. Fig. 4A is a top view of the TCB apparatus, and Fig. 4B is a section view of the apparatus of Fig. 4A taken along lines 4B-4B. The apparatus 400 generally includes a bond housing 410 defining a closed chamber 405 where TCB bonding occurs. It includes a pedestal415, position detectors 420A, 420B, bond head assembly 450 and bond head controller circuit 465.

The pedestal 415 has a vacuum suction mechanism 417 to hold substrates 470 (470A-470D) in place while the IC devices (IC1A through IC4C) are bonded to them by the bond head assembly 450. The bond head assembly 450 includes a nozzle 455 to hold an IC device in place while it is being bonded to target contacts 475. It has 3-dimensional (X-Y-Z) position control actuators (not shown) to position a device onto a set of target contacts based on control signals from controller circuit 465. As with controller circuit 265, controller circuit 465 may include any suitable combination of processors, micro-controllers, finite state machines, analog circuitry and/or sensors to implement a TCB bonding process with dynamic displacement tracking. For example, it may implement a routine in accordance with the flow diagram of Fig. 3 discussed above. In some embodiments, it may have, or have access to, a memory with instructions (e.g., firmware and/or programmable code) to be executed by one or more micro-controllers and/or processors to perform some or all bond head assembly and/or TCB control as described herein.

The position detectors 420A, 420B are spaced apart and face one another to monitor opposite sides of substrates 470 disposed there between. As with the assembly of Figs. 2A and 2B, they allow for both X and Y direction substrate displacement to be monitored without requiring the position detectors to be located at the assembly ends (or edges) that are orthogonal to the distance sensors.

With TCB apparatus 400, substrates 470 have fiducials 472 for monitoring substrate displacement. Accordingly, the position detectors 420A, 420B include fiducial position sense components to track the locations of the fiducials and thereby track substrate displacement. As used herein, a fiducial may be any mark or object placed in a field of operable perception of the position detectors 420A, 420B. For example, they may be marks having an identifiable characteristic such as shape, color, texture, or material type to be monitored by contactless fiducial position sensors such as optical systems (e.g., cameras, laser detectors), other optical sensors, magnetic field sensors, electric field sensors, acoustic sensors, and/or any other suitable sensors for determining fiducial positions in assembly 400.

The fiducial position detectors 420A, 420B are used to monitor both adjacent and orthogonal substrate edge displacement. As with the assembly of Figs 2A-2B, these measured, or monitored, displacements may be used to generate, or identify, derived adjacent-edge, orthogonal edge and/or overall resultant displacement vector values to control bond head positioning in order to reduce misalignment. In the depicted example, derived distances Y1a, Y'1a, Y1b, and Y'1b are shown for substrate 470A. Derived distances Y1a and Y1b are edge distances for substrate 470A before TCB occurs, while derived distances Y'1a and Y'1b are their counterpart adjacent displacement distances after substrate expansion has occurred. Accordingly, substrate expansion/contraction displacement for adjacent and orthogonal substrate edges may be tracked by the position detectors 420A, 420B, and used for adjusting bond head device position accordingly.

As shown in Fig. 4B, the fiducial detectors 420A, 420B may be placed at opposite sides of the pedestal near the vertical levels of the substrates. Alternatively, or in addition, they could be positioned higher up within the assembly such as is indicated with dashed detector symbols 420C, 420D. Desirable locations for the position detectors may depend on what types of fiducials are used and where they are placed on the substrates. for example, if on the edges, then the detectors may be lower in the assembly. On the other hand, in order to facilitate less obstruction with respect to the pedestal and bond head assembly, it may be desirable to locate them higher or lower within the assembly.

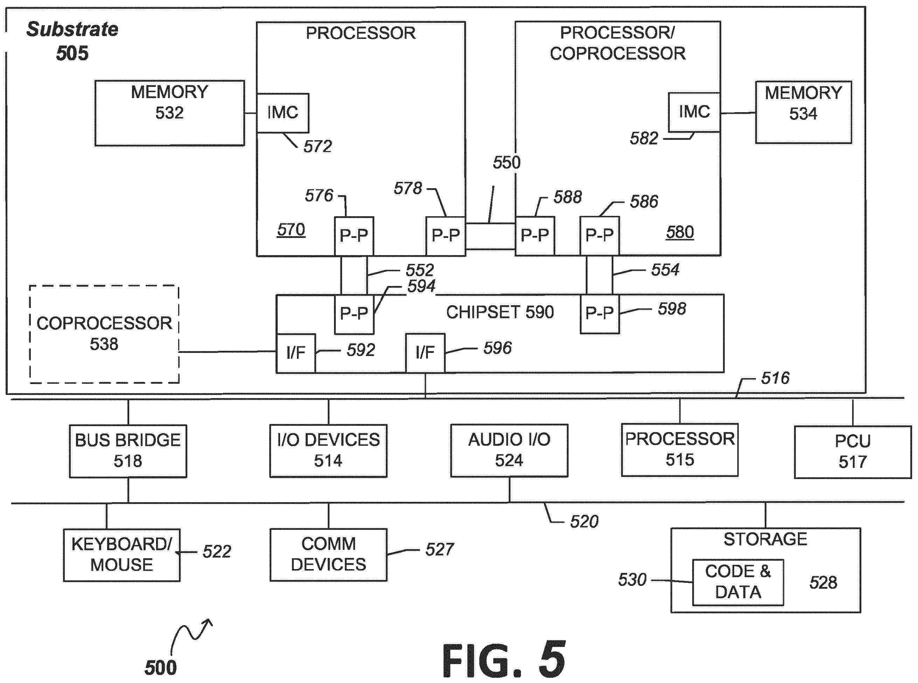

Fig. 5 illustrates an example computing system that may be formed from one or more devices bonded to a substrate, e.g., having one or more fiducials in accordance with some embodiments. Multiprocessor system 500 is an interfaced system and includes a plurality of processors including a first processor 570 and a second processor 580 coupled via an interface 550 such as a point-to-point (P-P) interconnect, a fabric, and/or bus. In some examples, the first processor 570 and the second processor 580 are homogeneous. In some examples, first processor 570 and the second processor 580 are heterogenous. Though the example system 500 is shown to have two processors, the system may have three or more processors, or may be a single processor system. In some examples, the computing system is implemented, wholly or partially, with a system on a chip (SoC) or a multi-chip (or multi-chiplet) module, in the same or in different device combinations that may be bonded to one or more substrates using a TCB process as described herein.

Processors 570 and 580 are shown including integrated memory controller (IMC) circuitry 572 and 582, respectively. Processor 570 also includes interface circuits 576 and 578, along with core sets. Similarly, second processor 580 includes interface circuits 586 and 588, along with a core set as well. A core set generally refers to one or more compute cores that may or may not be grouped into different clusters, hierarchal groups, or groups of common core types. Cores may be configured differently for performing different functions and/or instructions at different performance and/or power levels. The processors may also include other blocks such as memory and other processing unit engines.

Processors 570, 580 may exchange information via the interface 550 using interface circuits 578, 588. IMCs 572 and 582 couple the processors 570, 580 to respective memories, namely a memory 532 and a memory 534, which may be portions of main memory locally attached to the respective processors.

Processors 570, 580 may each exchange information with a network interface (NW I/F) 590 via individual interfaces 552, 554 using interface circuits 576, 594, 586, 598. The network interface 590 (e.g., one or more of an interconnect, bus, and/or fabric, and in some examples is a chipset) may optionally exchange information with a coprocessor 538 via an interface circuit 592. In some examples, the coprocessor 538 is a special-purpose processor, such as, for example, a high-throughput processor, a network or communication processor, compression engine, graphics processor, general purpose graphics processing unit (GPGPU), neural-network processing unit (NPU), embedded processor, or the like.

A shared cache (not shown) may be included in either processor 570, 580 or outside of both processors, yet connected with the processors via an interface such as P-P interconnect, such that either or both processors' local cache information may be stored in the shared cache if a processor is placed into a low power mode.

Network interface 590 may be coupled to a first interface 516 via interface circuit 596. In some examples, first interface 516 may be an interface such as a Peripheral Component Interconnect (PCI) interconnect, a PCI Express interconnect, or another I/O interconnect. In some examples, first interface 516 is coupled to a power control unit (PCU) 517, which may include circuitry, software, and/or firmware to perform power management operations with regard to the processors 570, 580 and/or co-processor 538. PCU 517 provides control information to one or more voltage regulators (not shown) to cause the voltage regulator(s) to generate the appropriate regulated voltage(s). PCU 517 also provides control information to control the operating voltage generated. In various examples, PCU 517 may include a variety of power management logic units (circuitry) to perform hardware-based power management. Such power management may be wholly processor controlled (e.g., by various processor hardware, and which may be triggered by workload and/or power, thermal or other processor constraints) and/or the power management may be performed responsive to external sources (such as a platform or power management source or system software).

PCU 517 is illustrated as being present as logic separate from the processor 570 and/or processor 580. In other cases, PCU 517 may execute on a given one or more of cores (not shown) of processor 570 or 580. In some cases, PCU 517 may be implemented as a microcontroller (dedicated or general-purpose) or other control logic configured to execute its own dedicated power management code, sometimes referred to as P-code. In yet other examples, power management operations to be performed by PCU 517 may be implemented externally to a processor, such as by way of a separate power management integrated circuit (PMIC) or another component external to the processor. In yet other examples, power management operations to be performed by PCU 517 may be implemented within BIOS or other system software. Along these lines, power management may be performed in concert with other power control units implemented autonomously or semi-autonomously, e.g., as controllers or executing software in cores, clusters, IP blocks and/or in other parts of the overall system.

Various I/O devices 514 may be coupled to first interface 516, along with a bus bridge 518 which couples first interface 516 to a second interface 520. In some examples, one or more additional processor(s) 515, such as coprocessors, high throughput many integrated core (MIC) processors, GPGPUs, accelerators (such as graphics accelerators or digital signal processing (DSP) units), field programmable gate arrays (FPGAs), or any other processor, are coupled to first interface 516. In some examples, second interface 520 may be a low pin count (LPC) interface. Various devices may be coupled to second interface 520 including, for example, a keyboard and/or mouse 522, communication devices 527 and storage circuitry 528. Storage circuitry 528 may be one or more non-transitory machine-readable storage media as described below, such as a disk drive or other mass storage device which may include instructions/code and data 530 and may implement the storage in some examples. Further, an audio I/O 524 may be coupled to second interface 520. Note that other architectures than the point-to-point architecture described above are possible. For example, instead of the point-to-point architecture, a system such as multiprocessor system 500 may implement a multi-drop interface or other such architecture.

Processor cores may be implemented in different ways, for different purposes, and in different processors. For instance, implementations of such cores may include: 1) a general purpose in-order core intended for general-purpose computing; 2) a high-performance general purpose out-of-order core intended for general-purpose computing; 3) a special purpose core intended primarily for graphics and/or scientific (throughput) computing. Implementations of different processors may include: 1) a CPU including one or more general purpose in-order cores intended for general-purpose computing and/or one or more general purpose out-of-order cores intended for general-purpose computing; and 2) a coprocessor including one or more special purpose cores intended primarily for graphics and/or scientific (throughput) computing. Such different processors lead to different computer system architectures, which may include: 1) the coprocessor on a separate chip from the CPU; 2) the coprocessor on a separate die in the same device as a CPU; 3) the coprocessor on the same die as a CPU (in which case, such a coprocessor is sometimes referred to as special purpose logic, such as integrated graphics and/or scientific (throughput) logic, or as special purpose cores); and 4) a system on a chip (SoC) that may be included on the same die as the described CPU (sometimes referred to as the application core(s) or application processor(s)), the above described coprocessor, and additional functionality. Example core architectures are described next, followed by descriptions of example processors and computer architectures.

Illustrative examples of the technologies disclosed herein are provided below. An embodiment of the technologies may include any one or more, and any compatible combination of, the examples described below.

Example 1 is an apparatus that includes a pedestal, a TCB bond head assembly, a controller circuit, and first and second position detectors. The pedestal supports a first substrate having a set of first substrate contacts. The bond head controller circuit controls a position of the bond head assembly to bond a device having a set of device contacts to the first substrate contacts. The first and second position detectors are mounted across from one another at opposite sides of the pedestal. They provide to the bond head controller circuit substrate edge displacement information to be used by the controller circuit to align the first substrate contacts with the device contacts during at least part of the TCB bonding process.

Example 2 includes the subject matter of example 1, and wherein the first position detector is aligned to face a first adjacent edge of the first substrate, and the second position detector is aligned to face a second adjacent edge of the first substrate, the first and second adjacent edges being across from one another.

Example 3 includes the subject matter of any of examples 1-2, and wherein the first position detector includes a first plurality of first distance sensors, and the second position detector includes a second plurality of second distance sensors.

Example 4 includes the subject matter of any of examples 1-3, and wherein the first plurality of distance sensors are positioned to generate first distance measurements to the first adjacent edge, and the second plurality of distance sensors are positioned to generate second distance measurements to the second adjacent edge, wherein the substrate edge displacement information includes the first and second distance measurements.

Example 5 includes the subject matter of any of examples 1-4, and wherein the first substrate has a first orthogonal edge that is orthogonal to the first adjacent edge, and it has a second orthogonal edge that is orthogonal to the second adjacent edge, the first and second orthogonal edges being across from one another, wherein the controller circuit is to generate orthogonal edge displacement information from the first and second distance measurements.

Example 6 includes the subject matter of any of examples 1-5, and wherein the first and second pluralities of distance sensors include distance sensors formed from light emitting diode lasers.

Example 7 includes the subject matter of any of examples 1-6, and wherein the pedestal is structured to support a second substrate that is next to the first substrate and positioned between the first and second position detectors.

Example 8 includes the subject matter of any of examples 1-7, and wherein the pedestal can move in opposite directions through a channel defined by the first and second position detectors.

Example 9 includes the subject matter of any of examples 1-8, and wherein the first and second position detectors include fiducial position detectors to identify fiducials located on the first substrate in order to provide the substrate edge displacement information.

Example 10 is a method. The method includes controlling a bond head assembly to align device contacts of a device with target substrate contacts of a substrate. The method further includes heating the device contacts and target substrate contacts. The method further includes monitoring thermal displacement between the device and target substrate contacts. The method further includes adjusting the position of the device contacts based on the monitored thermal displacement. The method further includes compressing the device contacts into the target substrate contacts.

Example 11 includes the subject matter of example 10, and wherein the heating of the target substrate and device contacts begins before the bond head assembly is controlled to align the device contacts with target substrate contacts.

Example 12 includes the subject matter of any of examples 10-11, and wherein the act of adjusting is performed at least partially during the act of compressing.

Example 13 includes the subject matter of any of examples 10-12, and wherein the acts of adjusting and compressing are alternately performed until the device and target substrate contacts are merged.

Example 14 includes the subject matter of any of examples 10-13, and wherein monitoring thermal displacement between the device and target substrate contacts includes identifying both X and Y edge displacement values for the substrate.

Example 15 includes the subject matter of any of examples 10-14, and wherein the Y displacement values are derived from a plurality of adjacent substrate edge measurements.

Example 16 includes the subject matter of any of examples 10-15, and wherein the X displacement values are derived from the plurality of adjacent substrate edge measurements.

Example 17 includes the subject matter of any of examples 10-16, and wherein identifying both X and Y edge displacement values includes identifying at least one position of at least one fiducial on the substrate.

Example 18 is a thermal compression bonding apparatus that has a controller circuit with circuitry to perform a method including the subject matter of any of examples 10-17.

Example 19 includes the subject matter of example 18, and wherein the apparatus includes memory with instructions to be performed by at least part of the circuitry to perform at least part of a method in accordance with the subject matter of any of examples 10-17.

Example 20 is an apparatus that includes the substrate and device as referenced in any of examples 10-19, and wherein the substrate has at least one fiducial whose position is to be identified for monitoring thermal displacement between the device and target substrate contacts.

Example 21 is an apparatus that includes a pedestal, a control circuit, and first and second position detectors. The pedestal supports a first substrate having a set of first substrate contacts. The control circuit controls a position of a thermal compression bonding (TCB) bond head assembly to bond a device having a set of device contacts to a set of first substrate contacts. The first and second position detectors are mounted across from one another at opposite sides of the pedestal. The first and second position detectors are to provide substrate edge displacement information to the control circuit to be used to align the first substrate contacts with the device contacts during at least part of the TCB bonding process.

Example 22 includes the subject matter of example 21, and further comprises a memory having instructions that when at least partially executed by the control circuit, perform a method comprising: controlling the TCB bond head assembly to align the device contacts with the first substrate contacts, heating the device contacts and the first substrate contacts, monitoring thermal displacement between the device contacts and the first substrate contacts, adjusting the position of the device contacts based on the monitored thermal displacement, and compressing the device contacts into the first substrate contacts.

Example 23 includes the subject matter of example 22, and wherein the heating of the first substrate and device contacts begins before the bond head assembly is controlled to align the device contacts with the first substrate contacts.

Example 24 includes the subject matter of any of examples 22-23, and wherein the act of adjusting is performed at least partially during the act of compressing.

Example 25 includes the subject matter of any of examples 22-24, and wherein the acts of adjusting and compressing are alternately performed until the device and first substrate contacts are merged.

Example 26 includes the subject matter of any of examples 22-25, and wherein monitoring thermal displacement between the device and target substrate contacts includes identifying both X and Y edge displacement values for the substrate.

Example 27 includes the subject matter of any of examples 22-26, and wherein the Y displacement values are derived from a plurality of adjacent substrate edge measurements.

Example 28 includes the subject matter of any of examples 22-27, and wherein the X displacement values are derived from the plurality of adjacent substrate edge measurements.

Example 29 includes the subject matter of example 21, and wherein the first position detector is aligned to face a first adjacent edge of the first substrate, and the second position detector is aligned to face a second adjacent edge of the first substrate, the first and second adjacent edges being across from one another.

Example 30 includes the subject matter of any of examples 21 or 29, and wherein the first position detector includes a first plurality of first distance sensors, and the second position detector includes a second plurality of second distance sensors.

Example 31 includes the subject matter of any of examples 21 or 29-30, and wherein the first plurality of distance sensors are positioned to generate first distance measurements to the first adjacent edge, and the second plurality of distance sensors are positioned to generate second distance measurements to the second adjacent edge, wherein the substrate edge displacement information includes the first and second distance measurements.

Example 32 includes the subject matter of any of examples 21 or 29-31, and wherein the first substrate has a first orthogonal edge that is orthogonal to the first adjacent edge, and it has a second orthogonal edge that is orthogonal to the second adjacent edge, the first and second orthogonal edges being across from one another, wherein the controller circuit is to generate orthogonal edge displacement information from the first and second distance measurements.

Example 33 includes the subject matter of any of examples 21 or 29-32, and wherein the first and second pluralities of distance sensors include distance sensors formed from light emitting diode lasers.

Example 34 includes the subject matter of any of examples 21 or 29-33, and wherein the pedestal is structured to support a second substrate that is next to the first substrate and positioned between the first and second position detectors.

Example 35 includes the subject matter of any of examples 21 or 29-34, and wherein the pedestal can move in opposite directions through a channel defined by the first and second position detectors.

Reference in the specification to "an embodiment," "one embodiment," "some embodiments," or "other embodiments" means that a particular feature, structure, or characteristic described in connection with the embodiments is included in at least some embodiments, but not necessarily all embodiments. The various appearances of "an embodiment," "one embodiment," or "some embodiments" are not necessarily all referring to the same embodiments. If the specification states a component, feature, structure, or characteristic "may," "might," or "could" be included, that particular component, feature, structure, or characteristic is not required to be included.

Throughout the specification, and in the claims, the term "connected" means a direct connection, such as electrical, mechanical, or magnetic connection between the things that are connected, without any intermediary devices.

The term "coupled" means a direct or indirect connection, such as a direct electrical, mechanical, or magnetic connection between the things that are connected or an indirect connection, through one or more passive or active intermediary devices.

The term "circuit" or "module" may refer to one or more passive and/or active components that are arranged to cooperate with one another to provide a desired function. It should be appreciated that different circuits or modules may consist of separate components, they may include both distinct and shared components, or they may consist of the same components. For example, A controller circuit may be a first circuit for performing a first function, and at the same time, it may be a second controller circuit for performing a second function, related or not related to the first function.

As used herein, the term device, IC, or IC device refers to a circuit device having one or more components contained therein, along with electrical contacts to electrically connect at least some of the components to another device outside of the device. Components may include, for example, semiconductor dies, electrical devices, mechanical devices, optical devices, and/or any other devices that include and/or interface with an electrical circuit. A device may have only one component, or it may include multiple components. The device may include a protective enclosure that houses the component(s), or with a suitable structure, it may constitute so-called bare chip technology such as with some flip chip and beam-lead technologies that can allow for direct connection of device components to a substrate. However, a device will typically provide physical protection, shielding delicate components from physical damage, moisture, dust, and other environmental factors. With TCB bonding, a device will typically include suitable structure to facilitate the device to be bonded to a substrate by a bond head assembly. Device contacts may include solder balls, bumps, micro-bumps, and/or any other suitable contacts for being bonded to counterpart contacts of a substrate pursuant to a utilized device bonding process.

The meaning of "in" includes "in" and "on" unless expressly distinguished for a specific description.

Unless otherwise specified, the use of the ordinal adjectives "first," "second," and "third," etc., to describe a common object, merely indicate that different instances of like objects are being referred to and are not intended to imply that the objects so described must be in a given sequence, either temporally, spatially, in ranking or in any other manner.

For the purposes of the present disclosure, phrases "A and/or B" and "A or B" mean (A), (B), or (A and B). For the purposes of the present disclosure, the phrase "A, B, and/or C" means (A), (B), (C), (A and B), (A and C), (B and C), or (A, B and C).

It is pointed out that those elements of the figures having the same reference numbers (or names) as the elements of any other figure can operate or function in any manner similar to that described but are not limited to such.

For purposes of the embodiments, unless expressly described differently, the transistors in various circuits and logic blocks described herein may be implemented with any suitable transistor type such as field effect transistors (FETs) or bipolar type transistors. FET transistor types may include but are not limited to metal oxide semiconductor (MOS) type FETs such as tri-gate, FinFET, and gate all around (GAA) FET transistors, as well as tunneling FET (TFET) transistors, ferroelectric FET (FeFET) transistors, or other transistor device types such as carbon nanotubes or spintronic devices.

In addition, well-known power/ground connections to integrated circuit (IC) chips and other components may or may not be shown within the presented figures, for simplicity of illustration and discussion, and so as not to obscure the disclosure. Further, arrangements may be shown in block diagram form in order to avoid obscuring the disclosure, and also in view of the fact that specifics with respect to implementation of such block diagram arrangements are dependent upon the platform within which the present disclosure is to be implemented.

As defined herein, the term "memory" means a storage medium that contains or stores program code for use by or in connection with an instruction execution system, apparatus, or device. As defined herein, a "memory" is not a transitory, propagating signal per se. A memory may be, but is not limited to, an electronic storage device, a magnetic storage device, an optical storage device, an electromagnetic storage device, a semiconductor storage device, or any suitable combination of the foregoing. Memory, may include, but is not limited to read only memory, nonvolatile read/writeable memory, volatile read/writeable memory, and the like.

As defined herein, the term "if" means "when" or "upon" or "in response to" or "responsive to," depending upon the context. Thus, the phrase "if it is determined" or "if [a stated condition or event] is detected" may be construed to mean "upon determining" or "in response to determining" or "upon detecting [the stated condition or event]" or "in response to detecting [the stated condition or event]" or "responsive to detecting [the stated condition or event]" depending on the context. As defined herein, the term "responsive to" means responding or reacting readily to an action or event. Thus, if a second action is performed "responsive to" a first action, there is a causal relationship between an occurrence of the first action and an occurrence of the second action. The term "responsive to" indicates the causal relationship.

As defined herein, the term "processor" means at least one hardware circuit configured to carry out instructions contained in program code. The hardware circuit may be implemented with one or more integrated circuits. Examples of a processor include, but are not limited to, a central processing unit (CPU), an array processor, a vector processor, a digital signal processor (DSP), a field-programmable gate array (FPGA), a programmable logic array (PLA), an application specific integrated circuit (ASIC), programmable logic circuitry, a graphics processing unit (GPU), a controller, a system on a chip (SoC), an application processor, an integrated circuit incorporating a combination of one or more of the aforesaid items, etc.

Certain techniques are described herein with reference to flowchart illustrations and/or block diagrams of methods, apparatus (systems), and computer program products. It will be understood that each block of a flowchart illustration and/or block diagram, and combinations of blocks in flowchart illustrations and/or block diagrams, may be implemented by computer readable program instructions, e.g., program code.

These computer readable program instructions may be provided to a processor of a general purpose computer, special purpose computer, or other programmable data processing apparatus to produce a machine, such that the instructions, which execute via the processor of the computer or other programmable data processing apparatus, create systems for implementing the functions/acts specified in flowchart(s) and/or block diagram block(s). These computer readable program instructions may also be stored in a computer readable storage medium that can direct a computer, a programmable data processing apparatus, and/or other devices to function in a particular manner, such that the computer readable storage medium having instructions stored therein comprises an article of manufacture including instructions which implement aspects of the operations specified in the flowchart(s) and/or block diagram block(s).

While the flow diagrams in the figures show a particular order of operations performed by certain embodiments of the invention, it should be understood that such order is exemplary (e.g., alternative embodiments may perform the operations in a different order, combine certain operations, overlap certain operations, etc.).

While the invention has been described in terms of several embodiments, those skilled in the art will recognize that the invention is not limited to the embodiments described, can be practiced with modification and alteration within the scope of the appended claims. The description is thus to be regarded as illustrative instead of limiting.

## Claims

1. An apparatus, comprising:
a pedestal to support a first substrate having a set of first substrate contacts;
a thermal compression bonding (TCB) bond head assembly;
a bond head controller circuit to control a position of the bond head assembly to bond a package having a set of package contacts to the first substrate contacts; and
first and second position detectors mounted across from one another at opposite sides of the pedestal, the first and second detectors to provide to the bond head controller circuit substrate edge displacement information to be used by the controller circuit to align the first substrate contacts with the package contacts during at least part of the TCB bonding process.

2. The apparatus of claim 1, wherein the first position detector is aligned to face a first adjacent edge of the first substrate, and the second position detector is aligned to face a second adjacent edge of the first substrate, the first and second adjacent edges being across from one another.

3. The apparatus of claim 2, wherein the first position detector includes a first plurality of first distance sensors, and the second position detector includes a second plurality of second distance sensors.

4. The apparatus of claim 3, wherein the first plurality of distance sensors are positioned to generate first distance measurements to the first adjacent edge, and the second plurality of distance sensors are positioned to generate second distance measurements to the second adjacent edge, wherein the substrate edge displacement information includes the first and second distance measurements.

5. The apparatus of claim 4, wherein the first substrate has a first orthogonal edge that is orthogonal to the first adjacent edge, and it has a second orthogonal edge that is orthogonal to the second adjacent edge, the first and second orthogonal edges being across from one another, wherein the controller circuit is to generate orthogonal edge displacement information from the first and second distance measurements.

6. The apparatus of any of claims 3-5, wherein the first and second pluralities of distance sensors include distance sensors formed from light emitting diode lasers.

7. The apparatus of any of claims 1-6, wherein the pedestal is structured to support a second substrate that is next to the first substrate and positioned between the first and second position detectors.

8. The apparatus of claim 7, wherein the pedestal can move in opposite directions through a channel defined by the first and second position detectors.

9. The apparatus of any of claims 1-8, wherein the first and second position detectors include fiducial position detectors to identify fiducials located on the first substrate in order to provide the substrate edge displacement information.

10. The apparatus of any of claims 1-9, wherein the bond head controller circuit is configured to perform a method comprising:
controlling the bond head assembly to align the package contacts with the first substrate contacts,
heating the package contacts and first substrate contacts,
monitoring thermal displacement between the package and first substrate contacts,
adjusting the position of the package contacts based on the monitored thermal displacement, and
compressing the package contacts into the first substrate contacts.

11. The apparatus of claim 10, wherein the heating of the target substrate and package contacts begins before the bond head assembly is controlled to align the package contacts with target substrate. contacts

12. The apparatus of any of claims 10-11, wherein the act of adjusting is performed at least partially during the act of compressing.

13. The apparatus of any of claims 10-12, wherein the acts of adjusting and compressing are alternately performed until the package and target substrate contacts are merged.

14. The apparatus of any of claims 10-13, wherein monitoring thermal displacement between the package and target substrate contacts includes identifying both X and Y edge displacement values for the substrate.

15. The apparatus of any of claims 10-14, wherein the Y displacement values are derived from a plurality of adjacent substrate edge measurements.
